# EUROPÄISCHE PATENTSCHRIFT

(11) **EP 0 897 542 B1**
(45) Veröffentlichungstag und Bekanntmachung des Hinweises auf die Patenterteilung: **06.10.1999**
(21) Anmeldenummer: 97921612.4
(22) Anmeldetag: 15.04.1997
(51) Int. Cl.: G01R 15/18, G01R 19/20, H01F 38/28

(54) **STROMSENSOR, INSBESONDERE FÜR KLEINE STRÖME**
CURRENT SENSOR, IN PARTICULAR FOR LOW CURRENTS
DETECTEUR DE COURANT, NOTAMMENT POUR COURANTS DE FAIBLE INTENSITE

(30) Priorität: 06.05.1996 DE 19618115
(43) Veröffentlichungstag der Anmeldung: 24.02.1999
(73) Patentinhaber: Vacuumschmelze GmbH, 63450 Hanau (DE)
(72) Erfinder: LENHARD, Friedrich, D-63452 Hanau (DE); HINZ, Gerhard, D-63755 Alzenau (DE)
(74) Vertreter: Epping, Wilhelm, Dr.-Ing.
(86) Internationale Anmeldenummer: DE9700754
(87) Internationale Veröffentlichungsnummer: WO9742510

(56) Entgegenhaltungen:
- EP-A- 0 314 234
- EP-A- 0 427 412
- WO-A-96/20408
- DE-A- 3 443 460
- DE-A- 4 019 810
- DE-A- 4 130 999
- DE-A- 4 229 948
- US-A- 4 314 200
- US-A- 4 325 096
- US-A- 5 508 606
- ELECTRONIC COMPONENTS AND APPLICATIONS, Bd. 3, Nr. 2, 1981, Seiten 101-109, XP002037230 J.A.HOULDSWORTH: "Purpose-designed ferrite toroids for isolated current measurement in power electronic equipment"
- IEEE TRANSACTIONS ON INSTRUMENTATION AND MEASUREMENT, Bd. 38, Nr. 6, 1.Dezember 1989, Seiten 1080-1082, XP000095935 DERAC SON ET AL: "A NEW CURRENT SENSOR BASED ON THE MEASUREMENT OF THE APPARENT COERCIVE FIELD STRENGTH"

## Beschreibung

Die Erfindung betrifft einen Stromsensor mit einem weichmagnetischen Magnetkern, auf dem neben einer Primärwicklung, in der der zu messende Strom fließt, mindestens eine Sekundärwicklung aufgewickelt ist, in die ein Wechselstrom eingespeist ist, der den Magnetkern in mindestens einer Richtung sättigt, und mit einer Auswerteschaltung, die aus den positiven und negativen Stromspitzen des sekundärseitigen Wechselstroms den Primärstrom in der Primärwicklung erzeugten Fluß in dem Magnetkern bestimmt.

In DE 42 29 948 A1 ist ein Stromsensor beschrieben, bei dem ein weichmagnetischer Magnetkern mit einer Primär- und einer Sekundärwicklung vorgesehen ist. In Reihe zu der Sekundärwicklung ist eine zusätzliche Stromquelle geschaltet, die durch die Sekundärwicklung einen Magnetisierungsstrom schickt, der den weichmagnetischen Magnetkern abwechselnd in die positive bzw. negative Sättigung steuert. Der weichmagnetische Magnetkern besitzt eine im wesentlichen rechteckförmige Magnetisierungskennlinie, so daß während der Ummagnetisierung zwischen zwei Sättigungszuständen ein jeweils konstanter Strom fließt, da infolge des nahezu senkrechten Verlaufs der Magnetisierungskennlinie der induktive Widerstand gegen unendlich geht.

Dieser Strom unterscheidet sich in der positiven bzw. negativen Halbwelle von einem Mittelwert jeweils durch einen Wert, der durch die Hysterese der Magnetisierungskennlinie gegeben ist. Durch Mittelwertbildung des während der Ummagnetisierung fließenden konstanten Stromes bei zwei aufeinanderfolgenden Halbwellen mit unterschiedlicher Polarität läßt sich der Einfluß der Hysterese in der Magnetisierungsschleife kompensieren, so daß die Messung des während der Ummagnetisierungszeit des Magnetkerns fließenden Stromes in der Sekundärwicklung einen Strom ergibt, der direkt proportional dem zu messenden Strom in der Primärwicklung ist.

Aufgabe der vorliegenden Erfindung ist es demgegenüber, einen einfach aufgebauten Stromsensor zu schaffen, der insbesondere zur Messung kleiner Ströme geeignet ist und mit einfachsten Mitteln bei Potentialtrennung einen Primärstrom erfassen kann.

Die Lösung dieser Aufgabe besteht erfindungsgemäß darin, daß der Magnetkern aus einem Material mit flacher, bis zur Sättigung linearer Magnetisierungskurve besteht, daß die Sekundärwicklung mit einer im wesentlichen sägezahnförmigen Spannung beaufschlagt wird und daß die Auswerteschaltung so aufgebaut ist, daß die positiven und negativen Stromspitzen erfaßt werden und eine Ausgangsspannung erzeugt wird, die dem Unterschied der positiven und negativen Stromspitzen proportional ist.

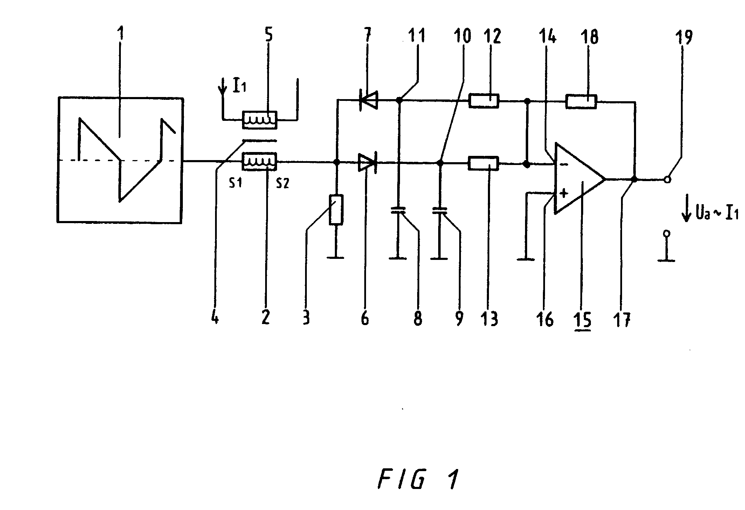

Ein Schaltbild des neuen Stromsensors ist in der Zeichnung dargestellt. Ein Generator 1 liefert eine im wesentlichen sägezahnförmige Spannung. Der Ausgang des Generators ist in Reihe zur Sekundärwicklung 2 des Stromsensors und in Reihe zu einem Widerstand 3 geschaltet. Der Stromsensor besitzt einen weichmagnetischen Magnetkern 4 und außerdem eine Primärwicklung 5 (im einfachsten Fall ein durchgesteckter Leiter), durch die der Strom I₁ fließt, der gemessen werden soll. Parallel zu dem Widerstand 3 liegen zur Erfassung der positiven und negativen Stromspitze jeweils eine Diode 6 und 7, die gegenpolig geschaltet sind und dazu in Reihe gegenüber Erde je ein Kondensator 8 und 9. Da die am Widerstand auftretende Spannung proportional dem Strom in der Sekundärwicklung 2 des Stromsensors ist, erhält man an den Anschlüssen 10 und 11 der Kondensatoren jeweils eine Spannung, die der positiven bzw. negativen Stromspitze im Sekundärkreis des Stromsensors entspricht. Über Widerstände 12 und 13 wird der Mittelwert dieser beiden Spannungen gebildet und an den Eingang 14 eines Verstärkers 15 angelegt. Der zweite Eingang 16 des Verstärkers 15 ist mit Erde verbunden und der Ausgang 17 des Verstärkers ist über einen Widerstand 18 auf den Eingang 14 des Verstärkers rückgekoppelt. Hierdurch entsteht am Ausgang 19 des Verstärkers 15 gegenüber Masse eine Ausgangsspannung, die - solange der weichmagnetische Magnetkern 4 nicht durch den zu messenden Primärstrom gesättigt ist - proportional zum Strom in der Primärwicklung 5 des Stromsensors ist.

Es ist also wesentlich, daß als weichmagnetischer Magnetkern im Gegensatz zum Bekannten ein Magnetkern mit flacher und bis zur Sättigung linearer Hystereseschleife gewählt wird, die über einen bestimmten Bereich eine Induktion liefert, die proportional zur Feldstärke ist. Da der Strom in der Sekundärwicklung 2 den weichmagnetischen Magnetkern 4 abwechselnd in die positive und negative Sättigung treibt, ist bei Vormagnetisierung durch den Primärstrom in der Primärwicklung 5, abhängig von dessen Polarität, die positive bzw. negative Sättigung eher erreicht, so daß sich unterschiedliche Spitzenwerte des Stromes im Sekundärkreis und damit auch im Widerstand 3 ergeben. Diese unterschiedlichen Spitzenwerte des Stromes führen zu unterschiedlicher Aufladung der Kondensatoren 8 bzw. 9, so daß über die Widerstände 12 und 13 eine Mittelwertbildung der Stromspitzen auf einfachste Weise vorgenommen werden kann.

Der erfindungsgemäße Stromsensor zeichnet sich durch besonders einfachen Aufbau aus und besitzt außerdem keinen durch Hysterese des Magnetkernwerkstoffes erzeugten Fehler.

## Patentansprüche

1. Stromsensor mit einem weichmagnetischen Magnetkern (4), auf dem neben einer Primärwicklung (5), in der der zu messende Strom fließt, mindestens eine Sekundärwicklung (2) aufgewickelt ist, in die ein Wechselstrom eingespeist ist, der den Magnetkern (4) in mindestens eine Richtung sättigt, und mit einer Auswerteschaltung, die die durch den Primärstrom in der Primärwicklung (5) erzeugte Flußunsymmetrie in dem Magnetkern bestimmt, **dadurch gekennzeichnet,** daß der Magnetkern (4) aus einem Material mit flacher und einer bis zur Sättigung linearen und in ihrer Steilheit der erforderlichen Empfindlichkeit anpaßbaren Magnetisierungskurve besteht, daß die Auswerteschaltung so aufgebaut ist, daß die positiven und negativen Stromspitzen erfaßt werden und daß eine Ausgangsspannung erzeugt wird, die der Summe der positiven und negativen Stromspitzen proportional ist.

2. Stromsensor nach Anspruch 1, **dadurch gekennzeichnet,** daß der in der Sekundärwicklung (2) fließende Wechselstrom im wesentlichen durch eine an die Sekundärwicklung angelegte sägezahnförmige Spannung erzeugt wird.

3. Stromsensor nach Anspruch 1, **dadurch gekennzeichnet,** daß zur Erfassung der positiven und negativen Stromspitzen die Auswerteschaltung an einen Widerstand (3) angeschlossen ist, der in Reihe zur Sekundärwicklung des Stromsensors liegt.

4. Stromsensor nach Anspruch 1, **dadurch gekennzeichnet,** daß ein Ausgangsverstärker (15) vorgesehen ist, an dessen Eingang (14) eine Spannung proportional zum Mittelwert der positiven und negativen Stromspitzen in der Sekundärwicklung anliegt.

## Claims

1. Current sensor having a soft-magnetic magnetic core (4), on which is wound, in addition to a primary winding (5), in which the current to be measured flows, at least one secondary winding (2), into which an AC current is fed which saturates the magnetic core (4) in at least one direction, and having an evaluation circuit, which determines the flux asymmetry, generated by the primary current in the primary winding (5), in the magnetic core, characterized in that the magnetic core (4) is composed of a material with a shallow magnetization curve which is linear to the point of saturation and can be adapted in terms of its gradient to the necessary sensitivity, in that the evaluation circuit is constructed in such a way that the positive and negative current peaks are detected and that an output voltage is generated which is proportional to the sum of the positive and negative current peaks.

2. Current sensor according to Claim 1, characterized in that the AC current flowing in the secondary winding (2) is essentially generated by a sawtooth-waveform voltage applied to the secondary winding.

3. Current sensor according to Claim 1, characterized in that in order to detect the positive and negative current peaks, the evaluation circuit is connected to a resistor (3), which is connected in series with the secondary winding of the current sensor.

4. Current sensor according to Claim 1, characterized in that an output amplifier (15) is provided, to whose input 14 a voltage proportional to the average value of the positive and negative current peaks in the secondary winding is applied.

## Revendications

1. Détecteur de courant avec un noyau magnétique doux (4) sur lequel se trouve, en plus d'un enroulement primaire (5) traversé par le courant que l'on veut mesurer, au moins un enroulement secondaire (2) alimenté par un courant alternatif qui sature le noyau magnétique (4) au moins dans une direction, et avec un circuit d'évaluation qui détecte l'asymétrie de flux produite dans le noyau magnétique par le courant primaire dans l'enroulement primaire (5) **caractérisé par le fait que** le noyau magnétique (4) est constitué d'un matériau ayant une courbe de magnétisation plate, linéaire jusqu'à la saturation et dont la pente est adaptable en fonction de la sensibilité requise, que le circuit d'évaluation est constitué de telle sorte que les pointes de courant positives et négatives soient détectées et qu'une tension de sortie proportionnelle à la somme des pointes de courant positives et négatives est générée.

2. Détecteur de courant selon la revendication 1 **caractérisé par le fait que** le courant alternatif qui circule dans l'enroulement secondaire (2) est essentiellement généré par une tension en dents de scie appliquée à l'enroulement secondaire.

3. Détecteur de courant selon la revendication 1 **caractérisé par le fait que,** pour la détection des pointes de courant positives et négatives, le circuit d'évaluation est connecté sur une résistance (3) montée en série sur l'enroulement secondaire du détecteur de courant.

4. Détecteur de courant selon la revendication 1 **caractérisé par le fait qu'il** est prévu un amplificateur de sortie (15) à l'entrée (14) duquel est appliquée une tension proportionnelle à la moyenne des pointes de courant positives et négatives dans l'enroulement secondaire.
